# FASCICULE DE BREVET EUROPEEN

(11) **EP 2 545 616 B1**
(45) Date de publication et mention de la délivrance du brevet: **06.08.2014**
(21) Numéro de dépôt: 11706853.6
(22) Date de dépôt: 09.03.2011
(51) Int. Cl.: H01R 13/52, H01R 43/24, H01R 13/58

(54) **DISPOSITIF DE CONNEXION ELECTRIQUE ETANCHE A TRAVERS UNE PAROI ET PROCEDE DE REALISATION CORRESPONDANT**
DICHTEN ELEKTRISCHEN VERBINDUNG VORRICHTUNG DURCH EINE WAND UND ENTSPRECHENDES HERSTELLUNGSVERFAHREN DAFÜR
SEALED ELECTRICAL CONNECTION DEVICE THROUGH A WALL AND CORRESPONDING METHOD FOR PRODUCING SAME

(30) Priorité: 09.03.2010 FR 1051682
(43) Date de publication de la demande: 16.01.2013
(73) Titulaire: Bontaz Centre R&D, 74460 Marnaz (FR)
(72) Inventeur: PEROTTO, Stéphane, F-74130 Ayse (FR); SAULNIER, Florian, F-74460 Marnaz (FR)
(74) Mandataire: Ilgart, Jean-Christophe
(86) Numéro de dépôt international: PCT/EP2011/053548
(87) Numéro de publication internationale: WO 2011/110599

(56) Documents cités:
- EP-A2- 0 696 827
- FR-A1- 2 906 411
- GB-A- 2 420 919
- US-A1- 2009 186 506
- US-B1- 7 530 843

## Description

### DOMAINE TECHNIQUE ET ART ANTÉRIEUR

La présente invention se rapporte à un dispositif de connexion électrique étanche à travers une paroi, par exemple pour connecter un capteur ou un dispositif actif, par exemple disposé dans un bloc moteur à une unité de commande extérieure au bloc moteur.

Dans le domaine automobile, de nombreux capteurs et de nombreux actionneurs sont utilisés, ceux-ci sont reliés à une unité centrale disposée dans un véhicule automobile. Les capteurs sont par exemple des capteurs de niveau de liquide, de température ou de pression, et les actionneurs sont par exemple des électrovannes ou des actuateurs.

Des capteurs et/ou des actionneurs peuvent être disposés par exemple dans le moteur, plus particulièrement dans le bloc moteur, alors que l'unité centrale est disposée dans le véhicule à un endroit quelconque. Des liaisons filaires sous la forme de faisceaux électriques sont alors prévues pour connecter les capteurs et actionneurs à l'unité centrale. Dans le cas des capteurs et actionneurs disposés dans le bloc moteur, les faisceaux électriques traversent le carter, cette traversée devant être étanche.

Généralement, le capteur ou actionneur comporte une portion de faisceau électrique munie à une extrémité d'un contact électrique destiné à être relié à un contact électrique d'un faisceau électrique connecté à l'unité centrale. Le faisceau électrique du capteur ou actionneur traverse la paroi du carter du bloc moteur et le contact électrique fait saillie à l'extérieur du bloc moteur où il est connecté au contact du faisceau électrique de l'unité centrale.

Un dispositif assurant la traversée étanche de la paroi de carter du bloc moteur comporte un connecteur, dit connecteur passe carter, réalisé en matériau plastique monté de manière étanche dans un passage traversant la paroi au moyen de joints disposés entre sa périphérie extérieure et le bord du passage dans la paroi de carter. Cette réalisation offre une étanchéité satisfaisante.

En revanche, des problèmes d'étanchéité se posent entre le connecteur passe carter, le faisceau électrique et le contact électrique du capteur ou actionneur.

Il existe plusieurs solutions pour réaliser une telle étanchéité.

L'une d'elles consiste à réaliser le contact électrique à partir d'une tôle découpée et pliée et à réaliser le connecteur passe carter par surmoulage directement sur le contact électrique. Cependant, l'étanchéité entre les brins de câbles du faisceau électrique et la partie surmoulée est délicate à obtenir. Des problèmes d'étanchéité peuvent apparaître du fait de la remontée de l'huile se trouvant dans le bloc moteur par capillarité le long des brins ou entre les brins des câbles du faisceau.

Une autre solution consiste à réaliser le contact électrique par usinage et à monter sur celui-ci un joint torique. Le connecteur passe carter est ensuite surmoulé directement sur le contact et le joint torique. Cette solution présente plusieurs inconvénients :
- Contrairement à un montage classique dans lequel le joint est monté dans un alésage, on réalise l'alésage autour du joint par surmoulage, il est alors difficile de prévoir le comportement du joint. L'étanchéité étant réalisée par le surmoulage, elle dépend donc directement des paramètres d'injection qui doivent par conséquent être contrôlés avec une grande précision.
- Le joint peut être détérioré lors du surmoulage par la température du matériau plastique, la vitesse et/ou la pression d'injection du matériau plastique. En cas d'endommagement du joint, celui-ci n'est pas détectable visuellement.
- La position axiale du contact électrique dans le connecteur passe carter n'est pas maitrisée puisque, lors de l'injection, le contact peut se déplacer dans le moule d'injection. Pour pallier cet inconvénient, on peut prévoir de maintenir le contact par une broche du moule, cependant le contact devient visible à travers le connecteur au niveau des passages de broche. Des risques de court-circuit peuvent alors survenir en présence d'un liquide conducteur.
- Enfin la précision requise pour la mise en place du contact dans le moule allonge le temps de surmoulage et augmente de fait le coût de fabrication du connecteur passe carter.

Le document GB 2 420 919 décrit in dispositif de connexion de câbles à une pompe immergée. Ce dispositif de connexion comporte un grand nombre de pièces, ce qui implique des problèmes de fiabilité puisque les risques de défauts d'assemblage et de le nombre de voies de fuite potentielles sont augmentés et un coût de revient important. Il n'est donc pas adapté à une application dans le domaine automobile dans lequel on cherche à simplifier les dispositifs et à réduire leur coût.

### EXPOSÉ DE L'INVENTION

C'est par conséquent un but de la présente invention, définie par les revendications ci-jointes, d'offrir un dispositif de connexion électrique permettant une traversée d'une paroi dont l'étanchéité est améliorée par rapport à ceux de l'état de la technique, en particulier permettant la traversée étanche d'une paroi de carter de bloc moteur, et offrant une conception simple et un nombre de pièces réduits.

Le but énoncé ci-dessus est atteint par un dispositif de connexion électrique à travers une paroi comportant un connecteur passe carter réalisé préalablement, muni d'une surface extérieure destinée à coopérer avec une surface d'une ouverture réalisée dans la paroi, et d'au moins deux alésages traversant, au moins deux contacts électriques, chacun à l'extrémité d'un faisceau électrique destiné à être connecté à un capteur ou un actionneur, les contacts électriques étant montés chacun dans un alésage, des moyens d'étanchéité étant interposés entre les contacts et la surface intérieure des alésages, et des moyens maintenant mécaniquement les faisceaux électriques par rapport au connecteur passe carter. Ces moyens de maintien mécanique sont réalisés sous la forme d'une pièce surmoulée entourant une portion des contacts faisant saillie de l'alésage et une portion des faisceaux électriques et solidaire du connecteur. Ainsi aucun surmoulage n'intervient dans l'étanchéité à travers la paroi, la partie surmoulée étant située à l'extérieur de l'ouverture dans la paroi. Les moyens d'étanchéité entre les contacts électriques et l'alésage passe carter étant par exemple réalisés par au moins un joint remplissant sa fonction classique, l'étanchéité est bien maîtrisée.

La pièce surmoulée assure également une isolation électrique entre les deux contacts électriques. En outre, elle maintient mécaniquement les contacts électriques évitant leur recul. En outre, la pièce surmoulée immobile les fils par rapport aux cosses des contacts électriques, évitant une rupture de la connexion électrique, par exemple due à la rupture des fils par fatigue, par exemple à cause des vibrations ou d'une mauvaise manipulation.

Ainsi l'invention, de manière très simple avec un nombre réduit de pièces, propose un dispositif de connexion robuste, de durée de vie allongée, de fabrication relativement simple et de prix de revient réduit. Ce dispositif de connexion est alors particulièrement adapté au domaine automobile.

Par ailleurs, le montage du contact dans l'alésage du connecteur passe carter peut être obtenu par la compression des joints dans l'alésage, à force, par encliquetage et/ou collage. Ainsi la position du contact est maîtrisée, et dans le cas d'une pièce surmoulée, sa réalisation ne risque pas de modifier la position du contact électrique. Par ailleurs, le montage est simplifié et rapide.

Dans une application à un bloc moteur, la partie surmoulée est disposée entièrement à l'intérieur du bloc moteur, la jonction entre cette partie surmoulée et le connecteur passe carter est donc disposée dans le bloc moteur en amont de l'étanchéité entre le bloc moteur et le connecteur passe carter dans le sens des fuites éventuelles. Par conséquent, la partie surmoulée n'a plus de fonction d'étanchéité, mais uniquement une fonction mécanique de maintien du ou des contact (s) et du ou des faisceau (x) et d'isolation électrique entre les contacts électriques. Une légère variation dans les paramètres d'injection pour la réalisation du surmoulage n'a alors pas d'impact sur ces fonctions. Même si la jonction entre la partie surmoulée et le connecteur passe carter n'est pas étanche, ceci n'est pas gênant, puisque les fuites sont stoppées par les joints disposés entre le connecteur passe carter et l'ouverture dans la paroi de carter du bloc moteur et entre le conducteur électrique et le connecteur passe carter.

Par ailleurs, grâce à l'invention, on peut utiliser des joints classiques dont l'efficacité est éprouvée pour réaliser toutes les étanchéités.

La présente invention a alors principalement pour objet un dispositif de connexion électrique étanche à travers une paroi comportant un connecteur muni d'au moins deux alésages, destiné à être disposé dans une ouverture de ladite paroi, au moins deux contact électriques reliés chacune à un faisceau électrique, lesdits contacts électriques étant entourés par des moyens d'étanchéité et disposés chacune dans un alésage du connecteur, les moyens d'étanchéité assurant l'étanchéité entre les contacts électriques et les alésages, ledit dispositif comportant également des moyens de maintien mécanique des faisceaux électriques sur le connecteur disposés à une extrémité de l'alésage du connecteur de telle sorte que, lorsque le dispositif est mis en place dans l'ouverture de la paroi, les moyens de maintien mécanique étant formés par une pièce surmoulée sur les faisceaux électriques, une extrémité des contacts électriques reliée aux faisceaux et une extrémité du connecteur, de telle sorte que, lorsque le dispositif est mis en place dans l'ouverture de la paroi, la jonction entre ladite pièce surmoulée et le connecteur se trouve d'un côté de la paroi.

De manière avantageuse, le contact électrique comporte dans sa périphérie extérieure au moins une gorge pour la mise en place d'au moins un joint, par exemple un joint torique, formant les moyens d'étanchéité. Le contact électrique peut comporter une portion extrémité destinée à venir en contact avec un autre contact électrique et une portion de plus grand diamètre du côté du faisceau électrique, ladite au moins une gorge recevant un joint étant réalisée dans ladite portion de plus grand diamètre, l'alésage comportant une portion médiane de plus petit diamètre pour le maintien de la portion d'extrémité.

Le contact électrique peut être maintenu dans l'alésage par la compression dudit au moins un joint et/ou par un montage à force dudit contact dans l'alésage et/ou par collage et/ou par encliquetage.

Le connecteur comporte de préférence des moyens de fixation de la partie de maintien mécanique. Dans l'exemple de réalisation où la pièce de maintien mécanique est une pièce surmoulée, ces moyens de fixation sont formés par des moyens d'accroche situés au niveau de l'extrémité sur laquelle la partie surmoulée est réalisée. Le connecteur comporte par exemple sur sa surface extérieure une portée destinée à assurer l'étanchéité avec la surface de l'ouverture de ladite paroi, et des moyens participant au blocage en position axiale du dispositif dans l'ouverture. Le connecteur peut également comporter au niveau de l'extrémité ouverte de l'alésage des moyens de solidarisation d'un contact électrique destiné à venir en contact avec le contact électrique dudit dispositif.

A titre d'exemple, le faisceau électrique est par exemple relié à un capteur ou un actionneur et le contact électrique est destiné à être relié à une unité centrale. La paroi, quant à elle, peut être la paroi de carter d'un bloc moteur d'un moteur de véhicule automobile et le capteur est un capteur de niveau de liquide, de pression ou de température et l'actionneur est une électrovanne ou un actuateur.

La présente invention a également pour objet un procédé de réalisation du dispositif de connexion électrique étanche selon la présente invention comportant les étapes :
- de réalisation du connecteur par injection de matière plastique,
- de réalisation du contact électrique et du faisceau électrique,
- de mise en place des moyens d'étanchéité autour du contact électrique,
- de mise en place du contact dans l'alésage du connecteur,
- de réalisation d'un maintien mécanique du faisceau, par exemple par encliquetage, par collage ou par surmoulage de la partie surmoulée par injection de matière plastique.

### BRÈVE DESCRIPTION DES DESSINS

La présente invention sera mieux comprise à l'aide de la description qui va suivre et des dessins en annexes sur lesquels :
- la figure 1 est une vue en coupe longitudinale en perspective d'un dispositif de connexion selon la présente invention ;
- la figure 2 est une vue coupe longitudinale en perspective du connecteur passe carter mis en oeuvre dans le dispositif de connexion de la figure 1 ;
- la figure 3 est une vue de détail des contacts électriques et des faisceaux électriques avant leur montage dans le connecteur passe carter ;
- la figure 4 est une vue en coupe longitudinale en perspective du dispositif de connexion selon l'invention avant la réalisation du surmoulage ;
- les figures 5A et 5B sont des vue en coupe longitudinale du dispositif selon la présente invention en place dans une ouverture d'une paroi et dudit dispositif connecté à un contact électrique relié à une unité centrale respectivement.

### EXPOSÉ DÉTAILLÉ DE MODES DE RÉALISATION PARTICULIERS

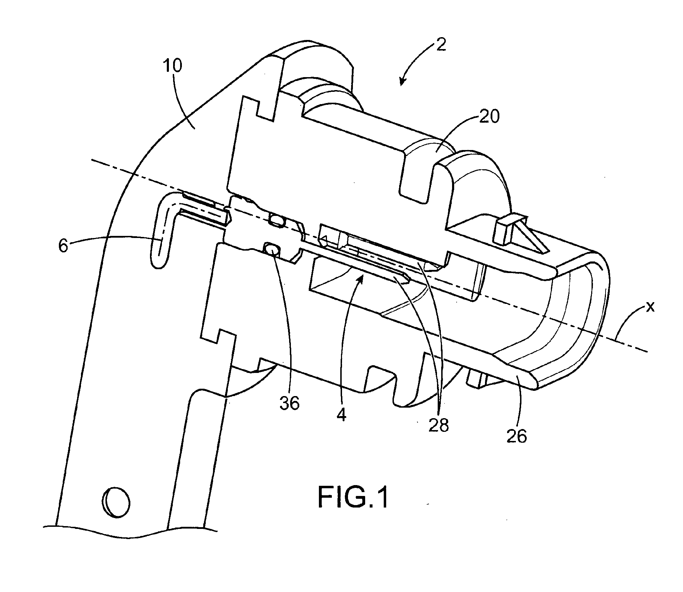

Sur la figure 1, on peut voir un exemple de réalisation d'un dispositif de connexion électrique à travers une paroi, par exemple une paroi de carter de bloc moteur d'un véhicule automobile destiné à connecter un élément situé dans le bloc moteur à une unité centrale disposée par exemple dans le compartiment moteur à distance du moteur.

Dans la description qui va suivre, nous considérerons, à titre d'exemple, que la paroi est une paroi de carter de bloc moteur, mais ceci n'est en aucun cas limitatif en ce qui concerne l'application de la présente invention.

L'élément à connecter est par exemple un élément de mesure, tel qu'un capteur de niveau de liquide, de pression, de température... ou un actionneur, tel qu'une électrovanne ou un actuateur, tel qu'un électroaimant. Dans la suite de la description, nous désignerons le capteur ou l'actionneur par le terme générique d'élément à connecter et ceci à des fins de simplicité.

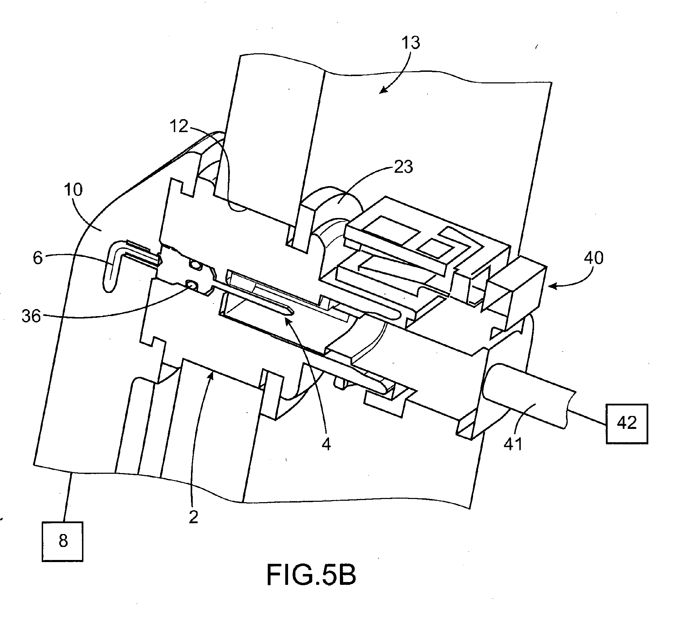

Le dispositif de connexion selon la présente invention représenté sur la figure 1 comporte une première pièce 2 ou connecteur, désignée par la suite connecteur passe carter, au moins un contact électrique 4, deux dans l'exemple représenté, un faisceau électrique 6 connecté électriquement à une extrémité de chaque contact électrique 4, l'autre extrémité du faisceau électrique 6 étant destinée à être connectée à l'élément à connecter 8 (représenté schématiquement sur la figure 5B) et des moyens de maintien mécanique du faisceau électrique sur le connecteur passe carter 2. Dans l'exemple représenté et de manière avantageuse, ces moyens de maintien sont formés par une partie surmoulée 10.

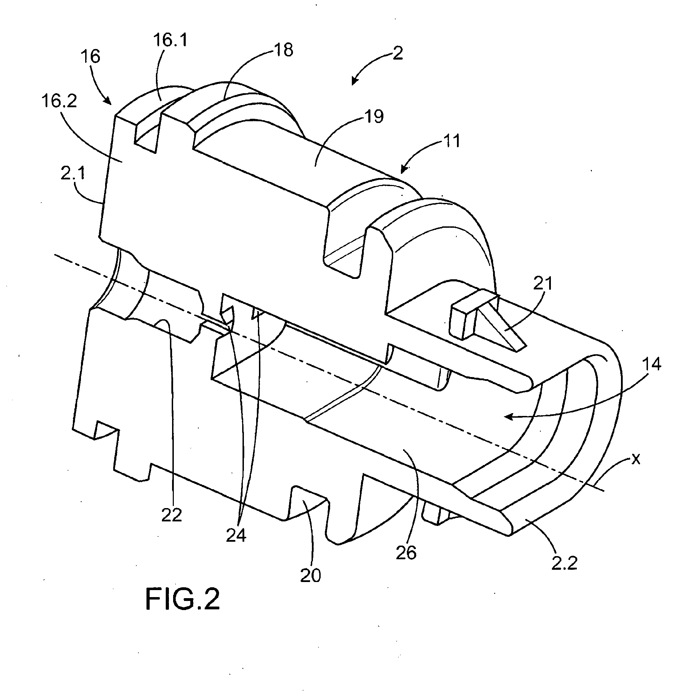

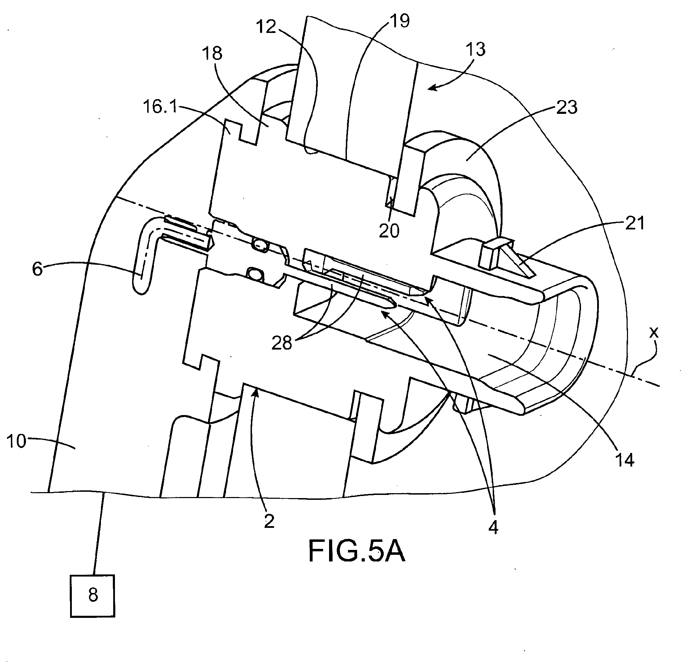

Le connecteur passe carter 2, représenté seul sur la figure 2, présente un axe longitudinal X. Le connecteur passe carter 2 comporte une surface extérieure 11 destinée à entrer en contact avec la surface d'une ouverture 12 (figure 5A) pratiquée dans une paroi 13 et deux alésages traversants 14 d'axe X, destinés chacun à loger un contact électrique.

Lorsque le dispositif selon la présente invention est monté dans l'ouverture 12 de la paroi à traverser, les extrémités longitudinales 2.1 et 2.2 font saillie de part et d'autre des faces intérieure et extérieure de la paroi 13. Une première extrémité 2.1 du connecteur passe carter 2 fait saillie dans le bloc moteur et une deuxième extrémité 2.2 du connecteur passe carter 2 fait saillie en dehors du bloc moteur.

Nous allons décrire la surface extérieure 10 du connecteur passe carter 2 de sa première extrémité longitudinale 2.1 vers sa deuxième extrémité longitudinale 2.2.

Dans l'exemple représenté, la première extrémité 2.1 comporte avantageusement des moyens 16 permettant une accroche améliorée de la partie surmoulée 10 sur le connecteur passe carter 2. Les moyens 16 sont, dans l'exemple représenté, formés par une couronne 16.1 disposée à l'extrémité d'un manchon 16.2 bordant une première extrémité 12.1 de l'alésage 12. La couronne 16.1 forme une saillie radiale que la partie surmoulée entoure, améliorant ainsi son accroche sur le connecteur passe carter.

La surface extérieure 11 comporte ensuite une saillie annulaire 18 destinée à venir en appui contre la face intérieure de la paroi 13. La saillie annulaire 18 peut être réalisée par surmoulage. La surface extérieure comporte ensuite une portée d'étanchéité 19 entre l'ouverture dans la paroi et le connecteur 2. La portée 19 peut par exemple coopérer avec des joints montés dans l'ouverture ou alors comporter des gorges pour le montage de joints.

La surface extérieure 11 comporte également en suivant une gorge annulaire 20 destiné à être située à l'extérieur du bloc moteur et destiné à recevoir un moyen de blocage en position axiale 23 (figure 5A) du dispositif de connexion dans l'ouverture, par exemple un anneau de blocage type clip ou agrafe, destiné à venir en appui contre la face extérieure de la paroi 13. La longueur de la portée 19 entre la saillie annulaire 18 et la gorge annulaire 20 est donc sensiblement égale à l'épaisseur de la paroi 13. D'autres moyens de blocage peuvent être prévu, il peut s'agir d'une goupille dans ce cas le connecteur comporte un logement pour la goupille, ou d'un filetage coopérant directement avec l'ouverture 12 ou avec un écrou disposé à l'extérieur du bloc moteur et venant s'appuyer sur la paroi 13.

Enfin, la deuxième extrémité 2.2 du connecteur passe carter 2 comporte des moyens de solidarisation 21 d'un contact électrique relié à une unité centrale. Dans l'exemple représenté, la deuxième extrémité se présente sous la forme d'une pièce mâle munie d'une saillie conique radialement vers l'extérieur pour assurer une fixation par encliquetage avec une pièce femelle.

Nous allons maintenant décrire les alésages 14. Ceux-ci comportent principalement trois portions 22, 24, 26 disposées axialement d'une première extrémité 4.1 du côté de l'intérieur du bloc moteur à une deuxième extrémité 4.2 du côté de l'extérieur du bloc moteur.

La première portion 22 de diamètre D₂₂ et la troisième portion 26 sont séparées par une portion 24 de section réduite.

Dans l'exemple représenté, les troisièmes portions 26 des deux alésages sont communes, les deux portions d'extrémité 28 des deux contacts électriques étant disposées parallèlement dans la portion unique 26.

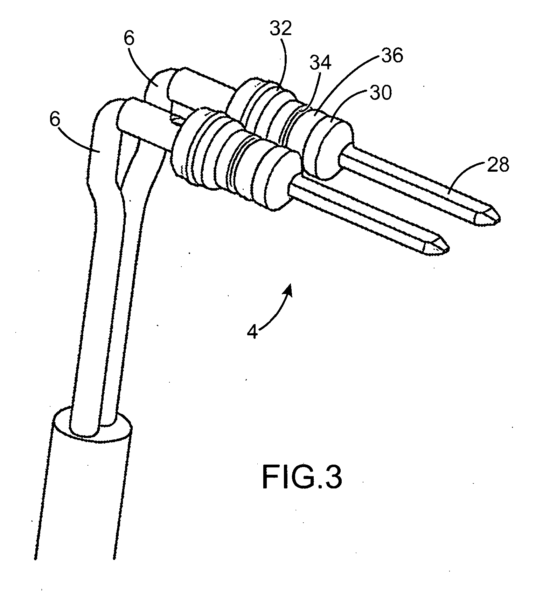

Sur la figure 3, on peut voir un exemple de réalisation de contacts électriques 4 pouvant être mis en oeuvre dans la présente invention.

Dans l'exemple représenté, le dispositif met en oeuvre deux contacts électriques sensiblement similaires, nous n'en décrirons qu'un seul en détail.

Le contact électrique 4 comporte une première portion d'extrémité 28 destinée à venir en contact avec le contact électrique relié à l'unité centrale, une portion médiane 30 portant les moyens d'étanchéité et une portion 32 reliée au faisceau électrique 6. Les fils du câble du faisceau électrique 6 sont sertis ou soudés sur le contact électrique.

Dans l'exemple représenté, la portion d'extrémité 29 comporte avantageusement une section rectangulaire coopérant avec la portion 24 présentant une section de forme sensiblement rectangulaire correspondante facilitant l'orientation du contact lors de son montage.

La portion médiane 30 comporte sur sa périphérie extérieure au moins une gorge 34, avantageusement plusieurs dans lesquelles sont montés des joints 36, par exemple des joints torique.

Le diamètre D₃₀ de la portion médiane 30 et celui de la première portion D₂₂ de l'alésage sont choisis pour assurer la compression des joints 36 et l'étanchéité entre le contact électrique et l'alésage.

Comme expliqué précédemment, la forme de la deuxième portion 24 de l'alésage est telle qu'elle permet le passage de la portion d'extrémité 28 du contact.

Dans l'exemple représenté, la première portion 22 de l'alésage se raccorde à la deuxième portion 24 par une forme tronconique facilitant la mise en place du contact électrique. La portion médiane du conducteur électrique a une forme correspondante. La forme conique de la portion 24 facilite également l'insertion du joint dans l'alésage.

Le contact électrique est maintenu dans le connecteur passe carter 2 par compression des joints, et/ou par un montage à force de la portion d'extrémité du contact dans la deuxième portion 24 de l'alésage et/ou par collage et/ou par encliquetage.

La troisième portion 26 de l'alésage, par l'intermédiaire d'un joint, assure l'étanchéité entre le dispositif de connexion selon l'invention et le contact électrique relié à l'unité de commande, ce joint réalise une étanchéité vis-à-vis de l'environnement extérieur au bloc moteur. Tout autre moyen pourrait être envisagé, on pourrait monter un joint sur la pièce femelle du contact électrique relié à l'unité centrale.

La partie surmoulée 10 est réalisée sur la portion d'accroche du connecteur passe carter et autour de la portion 32 du contact électrique et du faisceau électrique 6. La partie surmoulée 10 recouvre complètement les parties conductrices 32 des contacts électriques évitant un risque de court-circuit. Par ailleurs, elle assure un maintien dans une position donnée des faisceaux électriques et permet une manipulation aisée du dispositif de connexion pour sa mise en place dans l'ouverture de la paroi. La partie surmoulée 10 peut soit être en matériau rigide soit en matériau présentant une certaine souplesse en fonction de l'application et de la nécessité d'orienter le ou les faisceaux électriques.

En variante, le maintien mécanique du faisceau électrique peut être réalisé par encliquetage ou par collage, des pièces supplémentaires pouvant alors être prévues entre le faisceau et le connecteur.

Le connecteur passe carter et la partie surmoulée peuvent être réalisés en matériau thermoplastique ou élastomère.

Nous allons maintenant décrire un exemple d'un procédé de fabrication du dispositif de connexion électrique selon la présente invention comportant un seul contact électrique.

On réalise tout d'abord un connecteur passe carter par injection de matière plastique, ainsi qu'un contact électrique relié à un faisceau électrique. Le contact électrique est par exemple réalisé par usinage. Une ou plusieurs gorges sont usinées sur la périphérie extérieure de la portion médiane du contact électrique.

Lors d'une étape suivante, on met en place un joint torique dans chaque gorge du contact électrique. Le contact électrique est ensuite introduit dans l'alésage du connecteur passe carter, jusqu'à ce qu'il vienne en butée contre la portion 24 ou contre un appui quelconque du connecteur 2. Dans l'exemple représenté, de part sa section rectangulaire, la portion 24 sert à orienter le contact électrique dans le connecteur dont la portion 28 présente également une section rectangulaire.

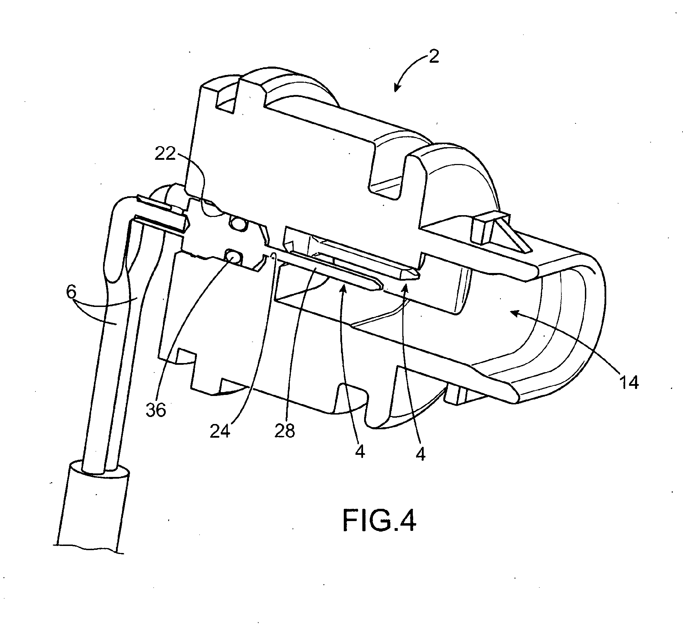

Les joints sont compressés et assurent l'étanchéité et éventuellement le maintien du contact. La portion d'extrémité 32 du contact électrique fait saillie dans la troisième portion de l'alésage selon une cote donnée. L'ensemble ainsi formé est visible sur la figure 4.

On peut prévoir également une étape de collage. Dans le cas où le maintien est obtenu par encliquetage, l'encliquetage a lieu simultanément au montage du contact électrique dans l'alésage.

L'ensemble connecteur passe carter/contact électrique et faisceau électrique ainsi formé est disposé dans un moule, le faisceau électrique étant disposé suivant l'orientation souhaitée. On réalise ensuite la partie surmoulée 10 par injection de matière plastique dans le moule. Cette injection ne provoque pas de déplacement du contact électrique, puisque celui-ci est maintenu par ailleurs fermement dans le connecteur passe carter 2.

On obtient alors le dispositif de connexion selon la présente invention prêt à être monté dans une ouverture de paroi et à être connecté à un élément disposé dans le bloc moteur et à une unité centrale.

Le montage d'un tel dispositif dans la paroi est visible sur les figures 5A et 5B et s'effectue de la manière suivante :

Le connecteur passe carter 2 est introduit dans l'ouverture 12 de la paroi 13 de sorte que sa saillie annulaire 18 vienne en butée contre la face intérieure de la paroi, et un moyen de blocage 23 est monté dans la gorge 20, assurant le maintien axial du dispositif dans la paroi. Ce moyen de blocage 22 peut être, dans l'exemple représenté, un clip ou une agrafe. Dans une variante de réalisation, il pourrait s'agir d'une goupille ou d'un filetage. Des joints peuvent être montés sur la portée du connecteur passe carter ou dans l'ouverture suivant l'option choisie.

Le faisceau électrique 6 situé dans le bloc moteur est connecté à l'élément à connecter 8. On connecte ensuite les contacts électriques 40 relié à l'unité centrale 42 via un faisceau électrique 41 au dispositif selon l'invention, l'assemblage étant réalisé dans l'exemple représenté par encliquetage.

Grâce à l'invention, on réalise l'étanchéité entre le dispositif de connexion et la paroi par un ou plusieurs joints et entre le ou les contacts électriques et le connecteur passe carter par un ou plusieurs joints. Les joints peuvent être des joints toriques employés dans leur rôle normal, assurant donc une très bonne étanchéité.

Les joints toriques présentent en outre l'avantage d'offrir une très bonne robustesse aux chocs thermiques, notamment lors des démarrages à froid, ce qui permet d'assurer une étanchéité dans toutes les configurations de fonctionnement, et ceci même dans le cas où la gaine des fils du faisceau électrique est percée par exemple lors de la réalisation de la partie surmoulée ou lors de l'utilisation du bloc moteur.

Par ailleurs, la remontée par capillarité de l'huile par exemple le long des fils du faisceau électrique n'est plus problématique puisque les joints toriques sont situés après le faisceau électrique dans le sens des fuites éventuelles.

Puisque ce n'est pas la partie surmoulée qui assure l'étanchéité, la pression d'injection peut être réduite. En outre, le surmoulage des fils des faisceaux électriques étant généralement problématique, on évite grâce à l'invention la nécessité d'obtenir un surmoulage de très bonne qualité à cet endroit.

Le dispositif de connexion selon la présente invention présente également l'avantage d'être de réalisation simple. En effet, la gestion de l'étape de surmoulage n'étant plus critique puisque ce n'est plus la partie surmoulée qui réalise l'étanchéité, cette étape peut être effectuée avec une précision moindre.

En outre, il n'y a pas de risque de modification de la position des contacts électriques. Il n'y a donc pas besoin d'utiliser des broches pour maintenir les contacts dans le moule, ceux-ci ne sont donc pas visibles lorsque le surmoulage est terminé. Et la mise en place de l'ensemble connecteur passe carter/contact électrique et faisceau électrique dans le moule est simplifiée.

Le bon positionnement du contact électrique dans l'alésage permet de respecter facilement une cote de dépassement déterminée de la portion d'extrémité du contact électrique, dont la tolérance, dans certaines applications peut être de l'ordre du 1/10^{ème}.

Dans l'exemple de réalisation comportant une pièce surmoulée, l'étape de surmoulage est plus simple et plus rapide, le moule est également simplifié puisque la forme de la partie surmoulée est très simple. Par conséquent, le coût de fabrication peut être réduit, d'autant plus que la réalisation du connecteur passe carter peut être réalisée de manière automatique.

Il est bien entendu que le dispositif de connexion peut permettre de connecter plus de deux contacts électriques simultanément. De préférence, le connecteur passe carter conserve sensiblement une géométrie de révolution au moins au niveau de la portée d'étanchéité, ce qui simplifie sa fabrication et la réalisation de l'étanchéité avec la paroi, les contacts électriques sont alors par exemple répartis de manière uniforme autour de l'axe de révolution.

Les contacts électriques montés dans un même connecteur passe carter peuvent être reliés pour certains à des capteurs et pour d'autres à des actionneurs. Par ailleurs, on peut prévoir que plusieurs de ces dispositifs de connexion selon l'invention soient montés à travers la paroi de carter d'un même bloc moteur.

La présente invention s'applique notamment à la connexion à travers la paroi d'un bloc moteur d'un moteur de véhicule automobile entre des capteurs et/ou actionneurs et une unité centrale.

Il est bien entendu que le dispositif de connexion électrique peut être mis en oeuvre à chaque fois qu'une connexion électrique étanche à travers une paroi est requise.

## Revendications

1. Dispositif de connexion électrique étanche à travers une paroi (13) comportant un connecteur (2) muni d'au moins deux alésages (14), destiné à être disposé dans une ouverture (12) de ladite paroi (13), au moins deux contact électriques (4) reliés chacune à un faisceau électrique (6), lesdits contacts électriques (4) étant entourés par des moyens d'étanchéité (36) et disposés chacune dans un alésage (14) du connecteur (2), les moyens d'étanchéité (36) assurant l'étanchéité entre les contacts électriques (4) et les alésages (14), ledit dispositif comportant également des moyens de maintien mécanique des faisceaux électriques sur le connecteur disposés à une extrémité de l'alésage du connecteur de telle sorte que, lorsque le dispositif est mis en place dans l'ouverture (13) de la paroi (12), la jonction entre les moyens de maintien mécanique et le connecteur (2) se trouve d'un côté de la paroi (13), les moyens de maintien mécanique étant formés par une pièce surmoulée (10) sur les faisceaux électriques (6), une extrémité des contacts électriques (4) reliée aux faisceaux (6) et une extrémité du connecteur (2).

2. Dispositif de connexion électrique étanche selon la revendication 1, dans lequel chaque contact électrique (4) comporte dans sa périphérie extérieure au moins une gorge (34) pour la mise en place d'au moins un joint (36), par exemple un joint torique, formant les moyens d'étanchéité.

3. Dispositif de connexion électrique étanche selon la revendication 2, dans lequel chaque contact électrique (4) comporte une portion extrémité (28) destinée à venir en contact avec un autre contact électrique et une portion de plus grand diamètre (30) du côté du faisceau électrique (6), ladite au moins une gorge (34) recevant un joint (36) étant réalisée dans ladite portion de plus grand diamètre (30), l'alésage comportant une portion médiane (24) de plus petit diamètre pour le maintien de la portion d'extrémité (28).

4. Dispositif de connexion électrique étanche selon l'une des revendications 1 à 3, dans lequel le connecteur (2) comporte des moyens de fixation des moyens de maintien mécanique du faisceau électrique.

5. Dispositif de connexion électrique étanche selon la revendication 4, dans lequel les moyens de fixation sont formés par des moyens d'accroche (16) de ladite partie surmoulée (10).

6. Dispositif de connexion électrique étanche selon l'une des revendications 1 à 5 en combinaison avec la revendication 2, dans lequel chaque contact électrique (4) est maintenu dans l'alésage (14) par la compression dudit au moins un joint (36) et/ou par un montage à force dudit contact dans l'alésage et/ou par collage et/ou par encliquetage.

7. Dispositif de connexion électrique étanche selon l'une des revendications 1 à 6, dans lequel le connecteur (2) comporte sur sa surface extérieure une portée (19) destinée à assurer l'étanchéité avec la surface de l'ouverture (12) de ladite paroi (13), et des moyens (23) participant au blocage en position axiale du dispositif dans l'ouverture (12).

8. Dispositif de connexion électrique étanche selon l'une des revendications 1 à 7, dans lequel le connecteur (2) comporte au niveau de l'extrémité ouverte de l'alésage (14) des moyens de solidarisation (21) d'un contact électrique (40) destiné à venir en contact avec le contact électrique (4) dudit dispositif.

9. Dispositif de connexion électrique étanche selon l'une des revendications 1 à 8, dans lequel le faisceau électrique (6) est relié à un capteur ou un actionneur et le contact électrique (4) est destiné à être relié à une unité centrale via un autre contact électrique.

10. Dispositif de connexion électrique étanche selon la revendication 9, dans lequel la paroi (13) est la paroi de carter d'un bloc moteur d'un moteur de véhicule automobile et le capteur est un capteur de niveau de liquide, de pression ou de température et l'actionneur est une électrovanne ou un actuateur.

11. Procédé de réalisation du dispositif de connexion électrique étanche selon l'une des revendications 1 à 10 comportant les étapes :
- de réalisation du connecteur (2) par injection de matière plastique,
- de réalisation du contact électrique (4) et du faisceau électrique (6),
- de mise en place des moyens d'étanchéité (36) autour du contact électrique (4),
- de mise en place du contact électrique (4) dans l'alésage (14) du connecteur (2),
- de réalisation d'un maintien mécanique du faisceau au moyen d'une partie surmoulée (10) par.sur les faisceaux électriques (6), une extrémité des contacts électriques (4) reliée aux faisceaux (6) et une extrémité du connecteur (2), ladite partie surmoulée (10) étant réalisée par injection de matière plastique.

## Patentansprüche

1. Dichten elektrischen Verbindung Vorrichtung durch eine Wand (13) hindurch, umfassend einen wenigstens zwei Bohrungen (14) enthaltenden Verbinder (2), dazu bestimmt, in einer Öffnung (12) der genannten Wand (13) angebracht zu werden, und wenigstens zwei elektrische Kontakte (4), jeder verbunden mit einem elektrischen Bündell (6), wobei die genannten elektrischen Kontakte (4) von Abdichteinrichtungen (36) umgeben sind und jeder sich in einer Bohrung (14) des Verbinders (2) befindet, und die Abdichteinrichtungen (36) dabei die Dichtheit zwischen den elektrischen Kontakten (4) und den Bohrungen (14) gewährleisten, wobei die genannte Vorrichtung auch mechanische Halteeinrichtungen der elektrischen Bündel in dem Verbinder umfasst, angeordnet an einem Ende der Bohrung des Verbinders, so dass, wenn die Vorrichtung in der Öffnung (12) der Wand (13) angebracht ist, sich die Verbindung zwischen den mechanischen Halteeinrichtungen und dem Verbinder (2) auf einer Seite der Wand (13) befindet, wobei die mechanischen Halteeinrichtungen durch ein Gussteil (10) gebildet werden, in das die elektrischen Bündel (6), ein Ende der mit den Bündeln (6) verbundenen elektrischen Kontakte (4) und ein Ende des Verbinders (2) eingegossen sind.

2. Dichten elektrischen Verbindung Vorrichtung nach Anspruch 1, bei der jeder elektrische Kontakt (4) an seiner Außenperipherie eine Nut (34) zur Aufnahme einer Dichtung (36), zum Beispiel einer die Abdichtungseinrichtungen bildenden Ringdichtung umfasst.

3. Dichten elektrischen Verbindung Vorrichtung nach Anspruch 2, bei der jeder elektrische Kontakt (4) ein Endstück (28), bestimmt zur Kontaktherstellung mit einem anderen elektrischen Kontakt, und auf der Seite des elektrischen Bündels (6) ein Stück (30) mit größerem Durchmesser umfasst, wobei die genannte, wenigstens eine, eine Dichtung (36) aufnehmende Nut (34) in dem genannten Teil (30) mit größerem Durchmesser enthalten ist und die Bohrung, um dem Endstück (28) Halt zu geben, einen mittleren Abschnitt (24) mit kleinerem Durchmesser umfasst.

4. Dichten elektrischen Verbindung Vorrichtung nach einem der Ansprüche 1 bis 3, bei der der Verbinder (2) Befestigungsmittel der Halteeinrichtungen des elektrischen Bündels umfasst.

5. Dichten elektrischen Verbindung Vorrichtung nach Anspruch 4, bei der die Befestigungsmittel durch Rasteinrichtungen (16) des genannten Gussteils (10) gebildet werden.

6. Dichten elektrischen Verbindung Vorrichtung nach einem der Ansprüche 1 bis 5 in Kombination mit Anspruch 2, bei der jeder elektrische Kontakt (4) in der Bohrung (14) festgehalten wird durch die Zusammenpressung der genannten wenigstens einen Dichtung (36) und/oder durch einen Presssitz des genannten Kontakts in der Bohrung und/oder durch Klebung und/oder durch Einkliken.

7. Dichten elektrischen Verbindung Vorrichtung nach einem der Ansprüche 1 bis 6, bei der der Verbinder (2) auf seiner Außenoberfläche eine Auflagefläche (19), dazu bestimmt, die Dichtheit mit der Oberfläche der Öffnung (12) der genannten Wand (13) zu gewährleisten, und Einrichtungen (23) umfasst, um die Vorrichtung in der Öffnung (12) in der axialen Position zu blockieren.

8. Dichten elektrischen Verbindung Vorrichtung nach einem der Ansprüche 1 bis 7, bei der der Verbinder (2) in Höhe des offenen Endes der Bohrung (14) Verbindungseinrichtungen (21) eines elektrischen Kontakts (40) umfasst, bestimmt für den Kontakt mit dem elektrischen Kontakt (4) der genannten Vorrichtung.

9. Dichten elektrischen Verbindung Vorrichtung nach einem der Ansprüche 1 bis 8, bei der das elektrische Bündel (6) mit einem Sensor oder einem Betätigungsgerät verbunden ist und der elektrische Kontakt (4) dazu bestimmt ist, über einen anderen elektrischen Kontakt mit einer Zentraleinheit verbunden zu werden.

10. Dichten elektrischen Verbindung Vorrichtung nach Anspruch 9, bei der die Wand (13) die Wand des Gehäuses eines Motorblocks eines Kraftfahrzeugmotors ist und der Sensor ein Flüssigkeits-, Druck- oder Temperaturniveaugeber ist und das Betätigungsgerät ein Elektroventil oder ein Aktuator ist.

11. Verfahren zur Herstellung einer dichten elektrischen Verbindung Vorrichtung nach einem der Ansprüche 1 bis 10 mit Schritten :
- zum Herstellen des Verbinders (2) durch Kunststoffspritzguss,
- zum Herstellen des elektrischen Kontaktes (4) und des elektrischen Bündels (6),
- zum Anbringen der Abdichteinrichtungen (36) um den elektrischen Kontakt (4) herum,
- zum Einsetzen des elektrischen Kontakts (4) in die Bohrung (14) des Verbinders (2),
- zum Herstellen eines mechanischen Halts des Bündels mittels Eingießens der elektrischen Bündel (6), eines Endes der mit den Bündeln (6) verbundenen elektrischen Kontakte und eines Endes des Verbinders (2) in das Teil (10) durch Kunststoffspritzguss.

## Claims

1. Sealed electrical connection device through a wall (13) comprising a connector (2) provided with at least two bores (14), which is intended to be arranged in an opening (12) of said wall (13), at least two electrical contacts (4) each connected to a wiring harness (6), said electrical contacts (4) being surrounded by sealing means (36) and each arranged in a bore (14) of the connector (2), the sealing means (36) assuring the sealing between the electrical contacts (4) and the bores (14), said device also comprising means of mechanically maintaining the electrical harnesses on the connector arranged at an end of the bore of the connector such that, when the device is put in place in the opening (13) of the wall (12), the junction between the mechanical maintaining means and the connector (2) is situated on one side of the wall (13), the mechanical maintaining means being formed by an over-moulded part (10) on the electrical harnesses (6), an end of the electrical contacts (4) connected to the harnesses (6) and an end of the connector (2).

2. Sealed electrical connection device according to claim 1, in which each electrical contact (4) comprises in its outer periphery at least one groove (34) for putting in place at least one gasket (36), for example an 0-ring seal, forming the sealing means.

3. Sealed electrical connection device according to claim 2, in which each electrical contact (4) comprises an end portion (28) intended to come into contact with another electrical contact and a portion of larger diameter (30) on the side of the wiring harness (6), said at least one groove (34) receiving a gasket (36) being formed in said portion of larger diameter (30), the bore comprising a median portion (24) of smaller diameter for maintaining the end portion (28).

4. Sealed electrical connection device according to one of claims 1 to 3, in which the connector (2) comprises means of fastening the means of mechanically maintaining the wiring harness.

5. Sealed electrical connection device according to claim 4, in which the fastening means are formed by means of attaching (16) said over-moulded part (10).

6. Sealed electrical connection device according to one of claims 1 to 5 in combination with claim 2, in which each electrical contact (4) is maintained in the bore (14) by the compression of said at least one gasket (36) and/or by a force fitting of said contact in the bore and/or by bonding and/or by clipping.

7. Sealed electrical connection device according to one of claims 1 to 6, in which the connector (2) comprises on its outer surface a span (19) intended to assure the sealing with the surface of the opening (12) of said wall (13), and means (23) participating in the blocking in axial position of the device in the opening (12).

8. Sealed electrical connection device according to one of claims 1 to 7, in which the connector (2) comprises at the open end of the bore (14) means of joining (21) an electrical contact (40) intended to come into contact with the electrical contact (4) of said device.

9. Sealed electrical connection device according to one of claims 1 to 8, in which the wiring harness (6) is connected to a sensor or an actuating unit and the electrical contact (4) is intended to be connected to a central unit via another electrical contact.

10. Sealed electrical connection device according to claim 9, in which the wall (13) is the crankcase wall of an engine block of an automobile vehicle engine and the sensor is a liquid, pressure or temperature level sensor and the actuating unit is an electromagnetic valve or an actuator.

11. Method of producing the sealed electrical connection device according to one of claims 1 to 10 comprising the steps:
- of forming the connector (2) by injection of plastic material,
- of forming the electrical contact (4) and the wiring harness (6),
- of putting in place sealing means (36) around the electrical contact (4),
- of putting in place the electrical contact (4) in the bore (14) of the connector (2),
- of assuring a mechanical maintaining of the harness by means of an over-moulded part (10) on the electrical harnesses (6), an end of the electrical contacts (4) connected to the harnesses (6) and an end of the connector (2), said over-moulded part (10) being formed by injection of plastic material.
